# EUROPEAN PATENT APPLICATION

(11) **EP 3 920 225 A1**
(43) Date of publication of application: **08.12.2021**
(21) Application number: 20748182.1
(22) Date of filing: 29.01.2020
(51) Int. Cl.: H01L 27/15, H01L 27/12, H01L 33/62, H01L 23/525, H01L 23/522

(54) **DISPLAY SUBSTRATE**

(30) Priority: 30.01.2019 KR 20190011816
(71) Applicant: Changsung Sheet Co., Ltd., Gyeonggi-do 10832 (KR)
(72) Inventor: BAEK, Seung Joon, Hwaseong-si Gyeonggi-do 18444 (KR); HWANG, Jae Sun, Seoul 04186 (KR)
(74) Representative: Schön, Christoph
(86) International application number: PCT/KR2020/001364
(87) International publication number: WO 2020/159226

(57) **Abstract**

The present invention relates to a display substrate and a method for manufacturing same. More specifically, the present invention provides a display substrate in which an electrical connection portion between a display sheet and a peripheral component electrically connected to the display sheet has improved heat resistance and durability, and a method for manufacturing same.

A display substrate according to the present invention includes: a flexible substrate on which a plurality of light-emitting elements is arranged; and a wiring portion which is formed on one surface of the flexible substrate and supplies power to the light-emitting elements. The wiring portion extends from a position at which the light-emitting elements are arranged towards one end portion of the flexible substrate, the one end portion of the flexible substrate is provided with a protrusion that protrudes in an extension direction of the wiring portion, the wiring portion extends to an end portion of the protrusion, and the flexible substrate and the protrusion may be integrally formed of the same material.

## Description

### Technical Field

This application claims the benefit of priority to Korean Patent Application No. 10-2019-0011816, filed on January 30, 2019, the entire disclosure of which is incorporated herein by reference.

The present invention relates to a display substrate and a method for manufacturing same. More specifically, the present invention provides a display substrate in which an electrical connection portion between a display sheet and a peripheral component electrically connected to the display sheet has improved heat resistance and durability, and a method for manufacturing same.

### Background Art

As a substrate having the LED installed thereon to connect the LED to other circuits and supplying power to the LED, there was typically used a PCB (printed circuit board) made of predominantly an FR4 resin or aluminum. Since a typical PCB is a hard board, the LED module manufactured with the PCB had to be made in the form of a crude bar.

With the recent development of a technology that uses a new material as a substrate for LEDs, there is a new trend in the LED display market. Attempts to use new materials as substrates are being promoted because they can impart new characteristics that products with general PCBs do not have. These characteristics can be 'transparency' and 'flexibility'.

There is a PET film as a material having transparency and flexibility. However, since the PET film is vulnerable to heat resistance, a material on which a separate wiring with high heat resistance is printed must be connected to the area where the wirings are concentrated. Since the material on which the separate wiring is printed is connected to the display substrate with an adhesive, the connection part generates more heat than other parts, and the problem of separation may occur due to weakened adhesion.

Korean Patent Registration No. 10-1689131 discloses a technology for 'Transparent Display Using Metal Mesh.'

### Detailed Description of the Invention

### Technical Problem

The present invention relates to a display substrate and a method for manufacturing same. More specifically, the present invention provides a display substrate in which an electrical connection portion between a display sheet and a peripheral component electrically connected to the display sheet has improved heat resistance and durability, and a method for manufacturing same.

The technical problems to be achieved by the present invention are not limited to the technical problems mentioned above, and other technical problems not mentioned will be clearly understood by those of ordinary skill in the art to which the present invention belongs from the following description.

### Solution to Problem

The display substrate of the present invention may comprise a flexible substrate on which a plurality of light-emitting elements is arranged; and a wiring portion which is formed on one surface of the flexible substrate and supplies power to the light-emitting elements, wherein the wiring portion extends from a position at which the light-emitting elements are arranged towards one end portion of the flexible substrate, the one end portion of the flexible substrate is provided with a protrusion that protrudes in an extension direction of the wiring portion, the wiring portion extends to an end portion of the protrusion, and the flexible substrate and the protrusion may be integrally formed of the same material.

### Effect of the Invention

The display device of the present invention eliminates chemical bonding such as a conductive adhesive in electrical connection with peripheral component such as a harness and has a structure that prevents thermal deformation of a substrate, thereby preventing problems such as disconnection and deformation.

In addition, in the display substrate of the present invention, a cumbersome process in which a separate FPCB must be adhered to the display sheet according to the shape of the circuit wiring may be omitted from the manufacturing step.

The display substrate of the present invention can be easily installed with respect to various installation environments because of its ease of bending and twisting deformation and can prevent disconnection or short circuit by preventing the surface from contracting or expanding.

### Brief Description of Drawings

Fig. 1 is a plan view showing a conventional display substrate.
Fig. 2 is a plan view showing a display substrate of the present invention.
Fig. 3 is a longitudinal sectional view showing a display substrate of the present invention.
Fig. 4 is a plan view showing an embodiment of the display substrate of the present invention.
Fig. 5 is a plan view showing another embodiment of the display substrate of the present invention.

### Best Mode for Carrying out the Invention

The display substrate of the present invention may comprise a flexible substrate on which a plurality of light-emitting elements is arranged; and a wiring portion which is formed on one surface of the flexible substrate and supplies power to the light-emitting elements, wherein the wiring portion extends from a position at which the light-emitting elements are arranged towards one end portion of the flexible substrate, the one end portion of the flexible substrate is provided with a protrusion that protrudes in an extension direction of the wiring portion, the wiring portion extends to an end portion of the protrusion, and the flexible substrate and the protrusion may be integrally formed of the same material.

In the display substrate of the present invention, the material of the flexible substrate may be a clear polyimide (CPI) that transmits 50% or more of light having a wavelength of 400 nm to 700 nm.

In the display substrate of the present invention, the CPI may comprise as a polymerization component an anhydride selected from the group consisting of 3,3',4,4'-biphenyl tetracarboxylic dianhydride(BPDA), bicycle[2.2.2]oct-7-ene-2,3,5,6-tetracarboxylic dianhydride(BTDA), 3,3',4,4'-diphenylsulfone tetracarboxylic dianhydride(DSDA), 4,4'-(hexafluoroisopropylidene)diphthalic anhydride(6FDA), 4,4'-oxydiphthalic anhydride(ODPA), pyromellitic dianhydride(PMDA), 4-(2,5-dioxotetrahydrofuran-3-yl)-1,2,3,4-tetrahydronaphthalene-1,2-dicarboxylic anhydride(DTDA), 4,4'-(4,4'-isopropylidenediphenoxy)-bis-(phthalicanhydride)(BPADA), 3,3',4,4'-benzotetracarboxylic dianhydride(BTDA), 1,2,3,4-Cyclobutane tetracarboxylic dianhydride(CBDA), 1,2,3,4-Cyclohexane tetracarboxylic dianhydride(CHDA), and 5-(2,5-Dioxotetrahydrofuryl)-3-methyl-3-cyclohexene-1,2-dicarboxylic anhydride(DOMDA); and a diamine selected from the group consisting of 2,2-Bis(3-amino-4-hydroxyphenyl)hexafluoropropane (BAHFP), 1,3-Bis(3-aminophenoxy)benzene (m-BAPB), 4,4'-Bis(4-aminophenoxy)biphenyl (p-BAPB), 2,2-Bis(3-aminophenyl)hexafluoropropane (BAPF), bis[4-(3-aminophenoxy)phenyl] sulfone (m-BAPS), 2,2-Bis [4-(4-aminophenoxy) phenyl] sulfone (p-BAPS), Bis(3-aminophenyl) sulfone (APS), m-xylylenediamine (m-XDA), p-xylylenediamine (p-XDA), 3,4'-Oxydianiline (3,4-ODA), 2,2-Bis(3-amino-4-methylphenyl)hexafluoropropane (BAMF), 4,4'-Diaminooctafluorobiphenyl, 3,3'-Dihydroxybenzidine, 2,2'-Ethylenedianilin, 2,2'-bis(trifluoromethyl)benzidine (TFB), 2,2',5,5'-Tetrachlorobenzidine, Bis(3-aminophenyl)methanone, 2,7-Diaminofluorene, 2-Chloro-p-phenylenediamine, 1,3-Bis(3-aminopropyl)-tetramethyldisiloxane, 1,1-Bis(4-aminophenyl) cyclohexane, 9,9-Bis(4-aminophenyl) fluorene, 5-(Trifluoromethyl)-1,3-phenylenediamine, 4,4'-methylenebis(2-methylcyclohexylamine), 4-Fluoro-1,2-phenylenediamine, 4,4'-(1,3-Phenylenediisopropylidene) bisaniline, 4-Nitro-1,3-phenylenediamine, 4-Chloro-1,3-phenylenediamine, 3,5-Diaminobenzonitrile, 1,3-bis(aminomethyl)cyclohexane (m-CHDA), 1,4-Bis(aminomethyl)cyclohexane (p-CHDA), 2,2-bis[4-(4-aminophenoxy)phenyl]hexafluoropropane (6FBAPP), 2,2'-Bis(trifluoromethyl)benzidine (MDB), 4,4'-Oxydianiline (4,4'-ODA), 2,2-Bis [4-(4-aminophenoxy)phenyl] propane (BAPP), 1,3-Cyclohexanediamine, 1,4-Cyclohexanediamine, and Bis(4-aminophenyl) sulfide (4,4'-SDA).

In the display substrate of the present invention, the material of the flexible substrate may be PET heat-treated at a temperature of 120 °C to 150 °C.

In the display substrate of the present invention, the protrusion may have the wiring portion printed on one side and an auxiliary sheet stacked on the other side.

In the display substrate of the present invention, a softening point of the auxiliary sheet may be higher than that of the protrusion, and a thermal conductivity of the auxiliary sheet may be higher than that of the protrusion.

In the display substrate of the present invention, a plurality of the light emitting-elements may be arranged on a first straight line that is an imaginary straight line formed on one surface of the flexible substrate, and the wiring portion connected to the light-emitting elements arranged on the first straight line may extend to the protrusion in a direction parallel to the first straight line.

In the display substrate of the present invention, the width of the wiring portion printed on the flexible substrate may be 0.3 µm to 1000 µm.

In the display substrate of the present invention, when a first light-emitting element is disposed farther from the protrusion than a second light-emitting element, the first light-emitting element being one of the light-emitting elements arranged on the first straight line and the second light-emitting element being the other light-emitting device, a width of the wiring portion connected to the first light-emitting element may be wider than a width of the wiring portion connected to the second light-emitting element.

In the display substrate of the present invention, a plurality of wiring portions is printed on one of the protrusions and the width of the wiring portion printed on the protrusion may be 1.1 times or more than the width of the wiring portion printed on the flexible substrate.

### Mode for Carrying out the Invention

Hereinafter, embodiments of the present invention will be described in detail with reference to the accompanying drawings. The size or shape of the components shown in the drawings may be exaggerated for clarity and convenience of description. In addition, terms specifically defined in consideration of the configuration and operation of the present invention may vary according to the intention or custom of users or operators. Definitions of these terms should be made based on the contents throughout this specification.

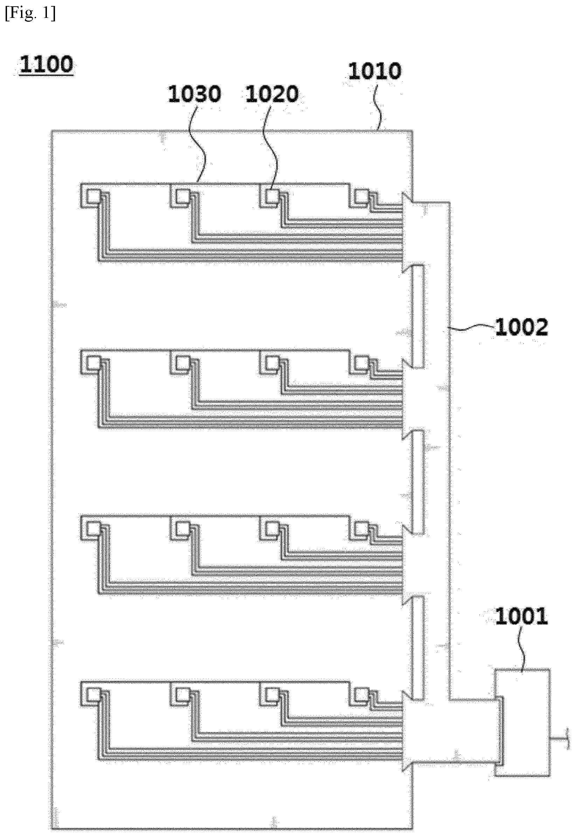

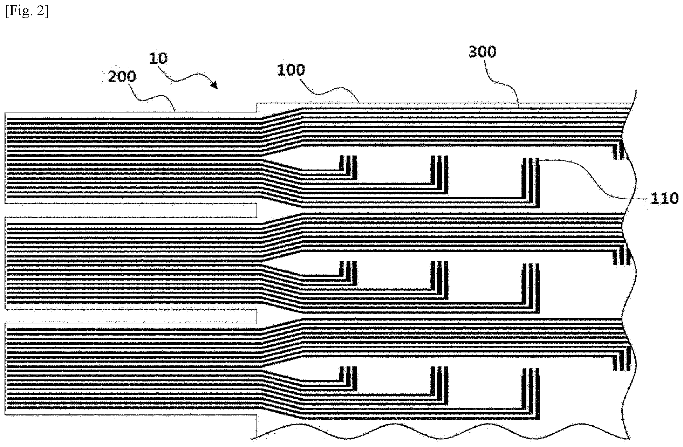

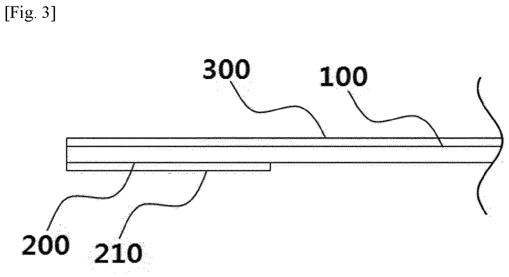

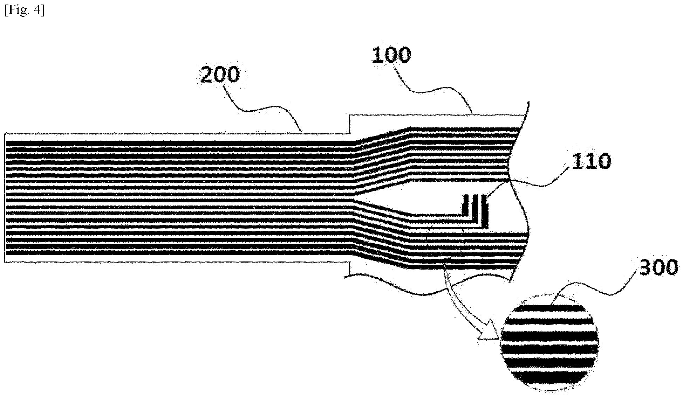

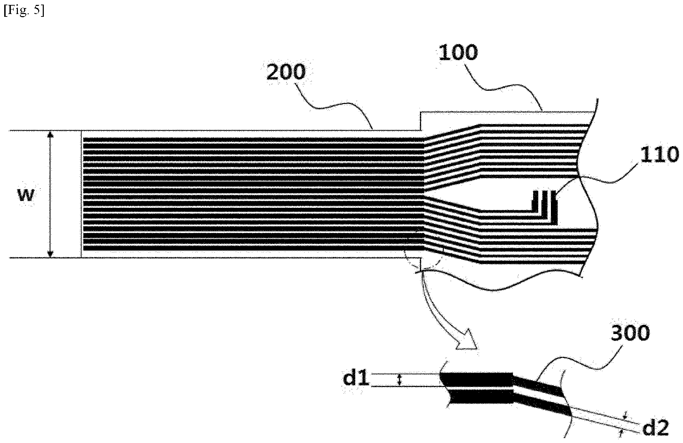

Fig. 1 is a plan view showing a conventional display substrate, Fig. 2 is a plan view showing a display substrate of the present invention, Fig. 3 is a longitudinal sectional view showing a display substrate of the present invention, Fig. 4 is a plan view showing an embodiment of the display substrate of the present invention, and Fig. 5 is a plan view showing another embodiment of the display substrate of the present invention.

Hereinafter, the configuration and function of the display substrate of the present invention will be described in detail with reference to Figs. 1 to 5.

As shown in Fig. 1, in a conventional display substrate 1100, a plurality of light-emitting elements is arranged on a main substrate 1010, and a power line for supplying power to the light-emitting element extends from the position 1020 at which the light-emitting element is arranged toward the edge of one end of the main substrate 1010. A flexible substrate (FPCB) 1002 may be adhered to one end of the main substrate 1010 with a conductive adhesive for electrical connection between the power line at the edge of one end of the main substrate and the peripheral component 1001 for supplying power. The peripheral component 1001 to which the flexible substrate is connected includes a harness or the like.

Since the width of the power line is on a micrometer scale, there is difficulty of adhering the flexible substrate to the main substrate by applying an adhesive at the correct position and controlling the position precisely.

In addition, the adhesion portion between the main substrate and the flexible substrate connected by a conductive adhesive has high resistance, so that heat generation become easier. As the heat is concentrated on the adhesion portion, the heat is transferred to the main substrate to cause deforming the shape of the main substrate.

In addition, since on/off of the light-emitting element is repeated many times for a short period of time, heating and cooling of the conductive adhesive frequently occur and the deterioration of the conductive adhesive is accelerated, causing the flexible substrate to be separated from the main substrate.

In other words, since the conventional display substrate has a structure in which the flexible substrate (FPCB) 1002 is adhered to the main substrate on which the light-emitting elements are disposed, there are problems of inconvenience of adhering the flexible substrate to the main substrate and heat generation and separation of the adhesion portion.

The display device of the present invention eliminates chemical bonding such as a conductive adhesive in electrical connection with peripheral component such as a harness and has a structure that prevents thermal deformation of a substrate, thereby preventing problems such as disconnection and deformation.

As shown in Fig. 2, the display substrate 10 of the present invention comprises a flexible substrate 100 on which a plurality of light-emitting elements is arranged, and a wiring portion 300 which is formed on one surface of the flexible substrate 100 and supplies power to the light-emitting elements, wherein the wiring portion 300 extends from a position 110 at which the light-emitting elements are arranged towards one end portion of the flexible substrate 100, the one end portion of the flexible substrate 100 is provided with a protrusion 200 that protrudes in an extension direction of the wiring portion 300, the wiring portion 300 extends to an end portion of the protrusion 200, and the flexible substrate 100 and the protrusion 200 may be integrally formed of the same material.

The flexible substrate 100 and the protrusion 200 may be a single fabric as a flat sheet. Specifically, a plurality of protrusions 200 may be provided at one end of the flexible substrate 100. Each of the protrusions 200 may be provided at a predetermined distance apart from each other. The protrusions 200 protrude in the longitudinal direction of the wiring portion 300 and a plurality of wiring portions 300 may be provided in each protrusion 200. In the display substrate 10 of the present invention, a circuit such as a wiring portion 300 is printed on a rectangular flexible sheet and then a part of the one end portion of the flexible sheet is cut to form the flexible substrate 100 and the protrusion 200. That is, a portion that is not cut off from the end portion of the flexible sheet may become the protrusion 200. The one end portion of the protrusion 200 may be connected to a peripheral component for supplying power. The peripheral component for supplying power may refer to an electrical connector element such as a harness.

That is, in the display substrate 10 of the present invention, the flexible substrate 100 and the protrusion 200 may be integrally formed of the same material as a single fabric. Therefore, unlikely a typical display substrate, it is possible to exclude an electrical connection connected by chemical bonding using an adhesive or the like.

The flexible substrate 100 and the protrusion 200 may be formed of a material that is easily bent and deformed, but has little deformation in contraction or expansion. That is, the flexible substrate 100 and the protrusion 200 are freely deformed with respect to flexural stress applied in a direction perpendicular to the surface but does not contract or expand with respect to the force applied in the horizontal direction to the surface maintain a uniform size. The display substrate 10 of the present invention can be easily installed with respect to various installation environments because of its ease of bending and twisting deformation and can prevent accidents of disconnection or short circuit by preventing the surface from contracting or expanding. The thickness of the flexible substrate 100 or the protrusion 200 that satisfies these requirements may be 10 µm to 700 µm. When the thickness of the flexible substrate 100 or the protrusion 200 is less than 10 µm, the flexible substrate 100 or the protrusion 200 may be torn or stretched by a small impact or tension. When the thickness of the flexible substrate 100 or the protrusion 200 is more than 700 µm, flexural stress of the flexible substrate 100 or the protrusion 200 becomes excessively large, the flexible substrate 100 or the protrusion 200 is undergone to bending deformation but may be broken, which may be disadvantageous in installing a complex structure and applying a roll process.

The display substrate 10 of the present invention can be easily installed on structures having various shapes because the surface of the flexible substrate 100 on which the light-emitting element is provided can be freely bent or twisted. Recently, the display substrate 10 has been attracting attention as an interior and exterior material in various field such as buildings and automobiles. Accordingly, there are increasing cases in which the display substrate 10 is required to be not only installed on a flat surface, but also on a curved surface. Since the display substrate 10 of the present invention has the portion where the light-emitting element is installed made of a flexible material, it can be easily installed even if the structure in which the display substrate 10 is installed has a complicated shape.

In addition, even if a peripheral component for supplying power exists in various positions, there can be good electrical connection because the protrusion 200 can be freely bent or twisted. The position of the peripheral component for supplying power may vary depending on a shape of the structure in which the display substrate 10 is installed, a design of the display device and tolerances. Since the protrusion 200 of the display substrate 10 of the present invention is integrally formed with the flexible substrate and made of a flexible material, the protrusion 200 can be easily connected to a peripheral component even if the position of the peripheral component for supplying power is changed.

In the display substrate 10 of the present invention, the material of the flexible substrate may be a clear polyimide (CPI) that transmits 50% or more of light having a wavelength of 400 nm to 700 nm.

Aromatic polyimide (PI) is a polymer with relatively low crystallinity or mostly amorphous structure, and has excellent heat and chemical resistance, excellent mechanical properties, electrical properties and dimensional stability due to its transparent and rigid chain structure. It is widely used in electric and electronic materials such as automobiles, aerospace fields, flexible circuit boards, liquid crystal alignment films for LCD, adhesives and coatings. Although it has numerous advantages that can be applied to insulating materials, flexible substrates, and aerospace, it is extremely limited in use in transparent flexible printed circuit boards (FPCB) and displays due to its unique dark color. The reason why PI has its own color can be explained by charge transfer complex (CT-complex) in which the π electrons of benzene present in the imide main chain are generated by intermolecular bonding, and electrons can be excited because σ electrons, π electrons, and nonbonding unshared electron pairs exist in the imide structure. In addition, in terms of π electron transitions, as the number of resonance structures increases, the transition of π electrons is facilitated, so the energy level is lowered, and high wavelength light, i.e., visible light is absorbed. In the case of water, as it absorbs high energy wavelength of 190 nm or less, it is transparent. In the case of general PI, as it absorbs light in the visible range from 400 nm to 500 nm, it has a color of yellow to red, which is the complementary color. CPI may use a monomer structure designed to reduce CT-complex while maintaining thermal and mechanical properties of PI.

CPI used as the material for the flexible substrate or the protrusion 200 of the display substrate 10 of the present invention may comprise as a polymerization component an anhydride selected from the group consisting of 3,3',4,4'-biphenyl tetracarboxylic dianhydride(BPDA), bicycle[2.2.2]oct-7-ene-2,3,5,6-tetracarboxylic dianhydride(BTDA), 3,3',4,4'-diphenylsulfone tetracarboxylic dianhydride(DSDA), 4,4'-(hexafluoroisopropylidene)diphthalic anhydride(6FDA), 4,4'-oxydiphthalic anhydride(ODPA), pyromellitic dianhydride(PMDA), 4-(2,5-dioxotetrahydrofuran-3-yl)-1,2,3,4-tetrahydronaphthalene-1,2-dicarboxylic anhydride(DTDA), 4,4'-(4,4'-isopropylidenediphenoxy)-bis-(phthalicanhydride)(BPADA), 3,3',4,4'-benzotetracarboxylic dianhydride(BTDA), 1,2,3,4-Cyclobutane tetracarboxylic dianhydride(CBDA), 1,2,3,4-Cyclohexane tetracarboxylic dianhydride(CHDA), and 5-(2,5-Dioxotetrahydrofuryl)-3-methyl-3-cyclohexene-1,2-dicarboxylic anhydride(DOMDA); and a diamine selected from the group consisting of 2,2-Bis(3-amino-4-hydroxyphenyl)hexafluoropropane (BAHFP), 1,3-Bis(3-aminophenoxy)benzene (m-BAPB), 4,4'-Bis(4-aminophenoxy)biphenyl (p-BAPB), 2,2-Bis(3-aminophenyl)hexafluoropropane (BAPF), bis[4-(3-aminophenoxy)phenyl] sulfone (m-BAPS), 2,2-Bis [4-(4-aminophenoxy) phenyl] sulfone (p-BAPS), Bis(3-aminophenyl) sulfone (APS), m-xylylenediamine (m-XDA), p-xylylenediamine (p-XDA), 3,4'-Oxydianiline (3,4-ODA), 2,2-Bis(3-amino-4-methylphenyl)hexafluoropropane (BAMF), 4,4'-Diaminooctafluorobiphenyl, 3,3'-Dihydroxybenzidine, 2,2'-Ethylenedianilin, 2,2'-bis(trifluoromethyl)benzidine (TFB), 2,2',5,5'-Tetrachlorobenzidine, Bis(3-aminophenyl)methanone, 2,7-Diaminofluorene, 2-Chloro-p-phenylenediamine, 1,3-Bis(3-aminopropyl)-tetramethyldisiloxane, 1,1-Bis(4-aminophenyl) cyclohexane, 9,9-Bis(4-aminophenyl) fluorene, 5-(Trifluoromethyl)-1,3-phenylenediamine, 4,4'-methylenebis(2-methylcyclohexylamine), 4-Fluoro-1,2-phenylenediamine, 4,4'-(1,3-Phenylenediisopropylidene) bisaniline, 4-Nitro-1,3-phenylenediamine, 4-Chloro-1,3-phenylenediamine, 3,5-Diaminobenzonitrile, 1,3-bis(aminomethyl)cyclohexane (m-CHDA), 1,4-Bis(aminomethyl)cyclohexane (p-CHDA), 2,2-bis[4-(4-aminophenoxy)phenyl]hexafluoropropane (6FBAPP), 2,2'-Bis(trifluoromethyl)benzidine (MDB), 4,4'-Oxydianiline (4,4'-ODA), 2,2-Bis [4-(4-aminophenoxy)phenyl] propane (BAPP), 1,3-Cyclohexanediamine, 1,4-Cyclohexanediamine, and Bis(4-aminophenyl) sulfide (4,4'-SDA).

The material of the flexible substrate 100 or the protrusion 200 of the display substrate 10 of the present invention may be PET heat-treated at a temperature of 120 °C to 150 °C. That is, the material of the flexible substrate 100 or the protrusion 200 may be PET in which the residual stress is eliminated and heat resistance is enhanced through annealing.

As shown in Fig. 3, the protrusion 200 may have the wiring portion 300 printed on one side and an auxiliary sheet 210 stacked on the other side. That is, the auxiliary sheet 210 for preventing a shape change of the protrusion 200 and dissipating heat from the protrusion 200 may be adhered to the protrusion 200 on a surface opposite to the surface on which the wiring portion 300 is formed. Therefore, a softening point of the auxiliary sheet 210 may be higher than that of the protrusion 200, and a thermal conductivity of the auxiliary sheet 210 may be higher than that of the protrusion 200. Even if an overcurrent flows due to the abnormal state in the wiring of the protrusion 200 to rise the temperature of the protrusion 200 higher than the softening point, the auxiliary sheet 210 supports the protrusion 200, so that the deformation of the protrusion 200 can be prevented. The contraction or expansion deformation of the protrusion 200 may cause disconnection or short circuit of the wiring portion 300, and secondary problems such as an operation error and acceleration of heating may occur. The auxiliary sheet 210 may enhance the operational stability of the display substrate 10 by preventing a change in the shape of the protrusion 200. In addition, since the protrusion 200 is made of a material having a high thermal conductivity, heat generated from the protrusion 200 can be rapidly released. The auxiliary sheet 210 may be a metal plate, a graphite sheet, or the like.

A plurality of light-emitting elements is arranged on a first straight line that is an imaginary straight line formed on one surface of the flexible substrate 100, and the wiring portion 300 connected to the light-emitting elements arranged on the first straight line may extent to the protrusion 200 in a direction parallel to the first straight line. It may be preferable that the wiring portion 300 is not visible to a person looking at the display substrate 10 from a predetermined distance or more. Accordingly, the wiring portion 300 may be formed with a width of a micrometer scale, and in some cases, may be formed with a width of a nanometer scale.

The wiring portion 300 printed on the flexible substrate may have a width of 300 nm or more. When the wiring portion 300 has a width of 300 nm or less, it may absorb visible light and obstruct observation of an object through the display substrate. In addition, it may be preferable that the longitudinal directions of the plurality of wiring portions 300 are unified in one direction and forming them in parallel. Therefore, even if one polarization component of light is absorbed, the other polarization component is preserved so that a person can recognize an object on the other side of the display substrate.

Accordingly, the width of the wiring portion 300 printed on the flexible substrate may be 0.3 µm to 1000 µm. The wiring portion 300 having a width of 1000 µm or more is easily visible to a person at a distance within 5 to 10 m, and thus it may be necessary to prevent this.

As shown in Fig. 4, in the case that a first light-emitting element is disposed farther from the protrusion 200 than a second light-emitting element, the first light-emitting element being one of the light-emitting elements arranged on the first straight line and the second light-emitting element being the other light-emitting device, a width of the wiring portion 300 connected to the first light-emitting element may be wider than a width of the wiring portion 300 connected to the second light-emitting element. That is, the width of the wiring portion 300 of the light-emitting element that is electrically connected to an external power source through the longer wiring portion 300 may be wider than the width of the wiring portion 300 of the light-emitting element that is electrically connected to an external power source through the shorter wiring portion 300.

In the transparent display substrate 10, it may be desirable that a circuit such as the wiring portion 300 printed on the substrate is as invisible as possible. Therefore, it may be desirable that the wiring portion 300 is printed with the narrowest possible width. As the width of the wiring portion 300 decreases, the resistance may increase according to the length of the wiring portion 300.

For one light-emitting element, the power consumption of the display substrate 10 is I²R1+I²R2, wherein R1 is the resistance of the light-emitting element and R2 is the resistance of the wiring portion. Here, I may be a current flowing through the light-emitting element. Here, I²R1 may be proportional to light intensity of the light-emitting element, and I²R2 may be proportional to heat generated in the wiring portion 300. Regardless of the length of the wiring portion 300, the value of the current I must be constant in order to generate light of the same intensity in the light-emitting element. Accordingly, as the value of current I is constant, R2 increase due to the lengthened wiring portion 300 and thus the heat generated in the wiring portion 300 may also increase. In addition, in order to keep the current I constant while the resistance is increased, the external power source needs to apply a larger voltage to the positive electrode of the wiring portion 300 connected to the light-emitting element, so that the load of the external power source may increase. Therefore, it may be preferred that as the length of the wiring portion 300 increases, the width of the wiring portion 300 increases.

When a plurality of wiring portions 300 is printed on one protrusion 200, the width d1 of the wiring portion 300 printed on the protrusion 200 may be wider than the width d2 of the wiring portion 300 printed on the flexible substrate 100. Preferably, the width of the wiring portion 300 printed on the protrusion 200 may be 1.1 times or more than the width of the wiring portion 300 printed on the flexible substrate 100.

As shown in Fig. 5, when the plurality of wiring portion 300 extend from the flexible substrate 100 to the end portion of one of protrusions 200, the width w of the protrusion 200 (the length in a direction perpendicular to the protruding direction of protrusion 200) may be narrower than the entire width of the plurality of wiring portions 300 printed on the flexible substrate 100. Here, the entire width of the plurality of wiring portions 300 means (n×d2)+((n-1)×d3)) when there are n wiring portions 300 and the wiring portions 300 are printed with a distance d3 apart from each other.

At this time, since the wiring portions 300 printed on the protrusion 200 are denser than the wiring portion 300 printed on the flexible substrate 100, more heat may be generated per unit area in the protrusion 200. Accordingly, the width of the wiring portion 300 in the protrusion 200 increases to lower the resistance of the wiring portion 300, thereby suppressing heat generation. In addition, since the end portion of the wiring portion 300 of the protrusion 200 is electrically connected by contacting an external component, the electrical connection may be more stably implemented with increasing the width.

Although the embodiments according to the present invention have been described above, these are merely exemplary, and those of ordinary skill in the art will understand that various modifications and equivalent ranges of embodiments are possible therefrom. Therefore, the true technical protection scope of the present invention should be determined by the following claims.

### Industrial Availability

The display device of the present invention eliminates chemical bonding such as a conductive adhesive in electrical connection with peripheral component such as a harness and has a structure that prevents thermal deformation of a substrate, thereby preventing problems such as disconnection and deformation.

In addition, in the display substrate of the present invention, a cumbersome process in which a separate FPCB must be adhered to the display sheet according to the shape of the circuit wiring may be omitted from the manufacturing step.

The display substrate of the present invention can be easily installed with respect to various installation environments because of its ease of bending and twisting deformation and can prevent accidents of disconnection or short circuit by preventing the surface from contracting or expanding.

## Claims

1. A display substrate comprising:
a flexible substrate on which a plurality of light-emitting elements is arranged; and
a wiring portion which is formed on one surface of the flexible substrate and supplies power to the light-emitting elements,
wherein the wiring portion extends from a position at which the light-emitting elements are arranged towards one end portion of the flexible substrate,
the one end portion of the flexible substrate is provided with a protrusion that protrudes in an extension direction of the wiring portion,
the wiring portion extends to an end portion of the protrusion, and
the flexible substrate and the protrusion may be integrally formed of the same material.

2. The display substrate according to claim 1, wherein the material of the flexible substrate is a clear polyimide (CPI) that transmits 50% or more of light having a wavelength of 400 nm to 700 nm.

3. The display substrate according to claim 2, wherein the CPI comprises as a polymerization component an anhydride selected from the group consisting of 3,3',4,4'-biphenyl tetracarboxylic dianhydride(BPDA), bicycle[2.2.2]oct-7-ene-2,3,5,6-tetracarboxylic dianhydride(BTDA), 3,3',4,4'-diphenylsulfone tetracarboxylic dianhydride(DSDA), 4,4'-(hexafluoroisopropylidene)diphthalic anhydride(6FDA), 4,4'-oxydiphthalic anhydride(ODPA), pyromellitic dianhydride(PMDA), 4-(2,5-dioxotetrahydrofuran-3-yl)-1,2,3,4-tetrahydronaphthalene-1,2-dicarboxylic anhydride(DTDA), 4,4'-(4,4'-isopropylidenediphenoxy)-bis-(phthalicanhydride)(BPADA), 3,3',4,4'-benzotetracarboxylic dianhydride(BTDA), 1,2,3,4-Cyclobutane tetracarboxylic dianhydride(CBDA), 1,2,3,4-Cyclohexane tetracarboxylic dianhydride(CHDA), and 5-(2,5-Dioxotetrahydrofuryl)-3-methyl-3-cyclohexene-1,2-dicarboxylic anhydride(DOMDA); and a diamine selected from the group consisting of 2,2-Bis(3-amino-4-hydroxyphenyl)hexafluoropropane (BAHFP), 1,3-Bis(3-aminophenoxy)benzene (m-BAPB), 4,4'-Bis(4-aminophenoxy)biphenyl (p-BAPB), 2,2-Bis(3-aminophenyl)hexafluoropropane (BAPF), bis[4-(3-aminophenoxy)phenyl] sulfone (m-BAPS), 2,2-Bis [4-(4-aminophenoxy) phenyl] sulfone (p-BAPS), Bis(3-aminophenyl) sulfone (APS), m-xylylenediamine (m-XDA), p-xylylenediamine (p-XDA), 3,4'-Oxydianiline (3,4-ODA), 2,2-Bis(3-amino-4-methylphenyl)hexafluoropropane (BAMF), 4,4'-Diaminooctafluorobiphenyl, 3,3'-Dihydroxybenzidine, 2,2'-Ethylenedianilin, 2,2'-bis(trifluoromethyl)benzidine (TFB), 2,2',5,5'-Tetrachlorobenzidine, Bis(3-aminophenyl)methanone, 2,7-Diaminofluorene, 2-Chloro-p-phenylenediamine, 1,3-Bis(3-aminopropyl)-tetramethyldisiloxane, 1,1-Bis(4-aminophenyl) cyclohexane, 9,9-Bis(4-aminophenyl) fluorene, 5-(Trifluoromethyl)-1,3-phenylenediamine, 4,4'-methylenebis(2-methylcyclohexylamine), 4-Fluoro-1,2-phenylenediamine, 4,4'-(1,3-Phenylenediisopropylidene) bisaniline, 4-Nitro-1,3-phenylenediamine, 4-Chloro-1,3-phenylenediamine, 3,5-Diaminobenzonitrile, 1,3-bis(aminomethyl)cyclohexane (m-CHDA), 1,4-Bis(aminomethyl)cyclohexane (p-CHDA), 2,2-bis[4-(4-aminophenoxy)phenyl]hexafluoropropane (6FBAPP), 2,2'-Bis(trifluoromethyl)benzidine (MDB), 4,4'-Oxydianiline (4,4'-ODA), 2,2-Bis [4-(4-aminophenoxy)phenyl] propane (BAPP), 1,3-Cyclohexanediamine, 1,4-Cyclohexanediamine, and Bis(4-aminophenyl) sulfide (4,4'-SDA).

4. The display substrate according to claim 1, wherein the material of the flexible substrate is PET heat-treated at a temperature of 120 °C to 150 °C.

5. The display substrate according to claim 1, wherein the protrusion has the wiring portion printed on one side and an auxiliary sheet stacked on the other side.

6. The display substrate according to claim 5, wherein a softening point of the auxiliary sheet is higher than that of the protrusion, and a thermal conductivity of the auxiliary sheet is higher than that of the protrusion.

7. The display substrate according to claim 1, wherein a plurality of the light emitting-elements is arranged on a first straight line that is an imaginary straight line formed on one surface of the flexible substrate, and
the wiring portion connected to the light-emitting elements arranged on the first straight line extends to the protrusion in a direction parallel to the first straight line.

8. The display substrate according to claim 7, wherein the width of the wiring portion printed on the flexible substrate is 0.3 µm to 1000 µm.

9. The display substrate according to claim 7, wherein in the case that a first light-emitting element is disposed farther from the protrusion than a second light-emitting element, the first light-emitting element being one of the light-emitting elements arranged on the first straight line and the second light-emitting element being the other light-emitting device, a width of the wiring portion connected to the first light-emitting element is wider than a width of the wiring portion connected to the second light-emitting element.

10. The display substrate according to claim 1, wherein a plurality of wiring portions is printed on one of the protrusions and the width of the wiring portion printed on the protrusion is 1.1 times or more than the width of the wiring portion printed on the flexible substrate.
